# EUROPEAN PATENT SPECIFICATION

(11) **EP 1 802 728 B1**
(45) Date of publication and mention of the grant of the patent: **09.01.2013**
(21) Application number: 05780712.5
(22) Date of filing: 21.07.2005
(51) Int. Cl.: C09K 11/79

(54) **PHOSPHOR AND LIGHT EMITTING DEVICE USING THE SAME**
LEUCHTSTOFF UND DAVON GEBRAUCH MACHENDE LICHTEMITTIERENDE VORRICHTUNG
PHOSPHORE ET DISPOSITIF D'EMISSION DE LUMIERE L'UTILISANT

(30) Priority: 18.10.2004 KR 20040083188
(43) Date of publication of application: 04.07.2007
(73) Proprietor: LG Innotek Co., Ltd., Seoul 100-714 (KR); Korea Research Institute of Chemical Technology, Yuseong-gu, Daejeon 305-343 (KR)
(72) Inventor: KIM, Chang Hae, Yousung-gu Daejun-si 305-755 (KR); PARK, Joung Kyu 7ho, 305dong, Gongdonggwanri Apt., Daejun-si 305-340 (KR); KIM, Sang Kee 307ho, 103dong, Chumdanmoa Apt.757-5, Gwangjoo-si 506-821 (KR); KIM, Chung Ryeol, Gwangjoo-si 500-220 (KR); CHOI, Kyoung Jae, Chungnam-si 343-812 (KR)
(74) Representative: Cabinet Plasseraud
(86) International application number: PCT/KR2005/002369
(87) International publication number: WO 2006/043745

(56) References cited:
- WO-A1-2004/085570
- JP-A- 05 334 999
- JP-A- 2003 132 803
- JP-A- 2003 336 048
- JP-A- 2004 176 010
- KR-A- 2004 085 039
- US-A1- 2003 085 853
- US-B2- 6 762 548

## Description

### [Technical Field]

The present invention relates to a phosphor and a light emitting device using the same, and particularly, to a phosphor which is excited by any wavelength of light and emits other wavelength of light and a light emitting device using the same. More particularly, it relates to a phosphor emitting white light by a specific wavelength of light and a light emitting device using the same.

### [Background Art]

A method of manufacturing a white light emitting device which has been recently vigorously progressed in worldwide is divided into a phosphor application method which obtains white color by adding a phosphor on a blue color or ultraviolet ray light emitting device in a single chip form and a multi chip method which obtains white color by combining a plurality of light emitting chips to each other in a multi chip form.

Specifically, a representative method of embodying a white light emitting device in the multi chip form is to manufacture by combining three chips of RGB (Red, Green, and Blue). However, the method has problems in that non-uniformity of an operating voltage in each chip and a color coordinate change by the output change in each chip depending on surrounding temperature. Due to such problems, the multi chip method can be properly applied to a purpose of special illumination required for the display of various colors by adjusting brightness of each light emitting device through a circuit structure than the embodiment of a white light emitting device.

Under such a background, a preferable method among methods of embodying a white light emitting device mainly uses a system combining a blue color light emitting device which has a relatively easy manufacturing method and an excellent efficiency with a phosphor which is excited by the blue color light emitting device and emits yellow color. In this way, a representative example of a system emitting white light using a phosphor uses a blue color light emitting device as an excitation light source and excites as an excitation light source emitting a yttrium aluminum garnet (YAG) phosphor, that is, a YAG:Ce phosphor which uses a cerium ion (Ce³⁺) that is a rare earth trivalent ion as an activator from a blue color light emitting device.

The white light emitting device can be used as various forms of package according to the utilization field. Representative white light emitting devices are classified roughly into a chip light emitting device (Chip LED) manufactured in a surface mounting device (SMD) form for applying to backlighting of a cellular phone and a vertical lamp using in a electric scoreboard, a solid display device, and an image display.

On the other hand, indexes for using in analyzing a light characteristic of the white light emitting device are a correlated color temperature (CCT) and color rendering index (CRI) .

In a case where a color of the moment that an object shines by omitting visible rays looks like the same as that in which some temperature of black body radiates, a temperature of the black body is regarded as the same as that of an object, and the correlated color temperature (CCT) means the temperature. As a color temperature is higher, the color becomes white color which is dazzling and tinged with blue color. That is, among the same white light, the white light having a low color temperature is felt somewhat warm, but the white light having a high color temperature is felt somewhat cold. Therefore, by adjusting the color temperature, a characteristic of special illumination requiring various color senses can be satisfied.

A white light emitting device using a YAG:Ce phosphor has a somewhat high color temperature of 6000 to 8000K.

The color rendering index (CRI) means the degree that an object color becomes different when lighting artificially manufactured is illuminated, compared with when sunlight is irradiated to an object and a CRI value is defined as 100 when a color of an object is the same as that of sunlight. That is, the color rendering index is an index showing the degree that an object color under an artificial lighting is near with a color when sun light is irradiated and has a figure from 0 to 100. Therefore, a white light source that the CRI approaches to 100 has no difference from an object color that a human's eye recognizes under the sun light.

The CRI of an incandescent lamp is 80 or more and that of a while fluorescent lamp is 75 or more, but the CRI of a commercialized white LED is approximately in a range of 70 to 75.

Therefore, there is a problem in that a color temperature of a white light emitting device using a conventional YAG:Ce phosphor is somewhat high and the color rendering index thereof is somewhat low. Further, because only the YAG:Ce phosphor is used, it is difficult to control a color coordinate, a color temperature, and a color rendering index.

Further, the YAG is relatively thermally deteriorated at a temperature of 100°C or more and uses Y₂O₃ among a nature material in composing the YAG and requires a high temperature of heat treatment at a temperature of 1500°C or more, thereby having a disadvantage in a production price.

Further, in order to change a light emitting main peak of the YAG to a red color area, when a rare earth trivalent ion is doped, light emitting brightness reduces.

Further white light emitting devices comprising an LED chip and a phosphor are also known from the prior art, for example document WO 2004/085570 A1 discloses a white light emitting device comprising an LED chip and a strontium silicate-based, bivalent europium activated phosphor, which is excited by a light emitted from the LED chip and expressed by the following chemical formula Sr₃₋ₓSiOₛ:Eu²⁺ₓ, wherein x is 0 < x < 1.

### [Disclosure]

### [Technical Problem]

The present invention is contrived to solve the above-mentioned problem and it is an object of the present invention to provide a phosphor having a thermal stability higher than a garnet phosphor and an improved characteristic and a light emitting device using the same.

It is another object of the present invention to provide a phosphor in which silicate phosphors are mixed and included in a mold material of a light emitting device and a light emitting device using the same in order to control a color coordinate, a color temperature, and a color rendering index.

It is still another object of the present invention to provide a phosphor capable of obtaining light suitable in various taste of a user and a light emitting device using the same so that a control of a color coordinate, a color temperature, and a color rendering index is possible by adjusting a mixed ratio of the phosphor.

It is still further object of the present invention to provide a phosphor capable of reducing a manufacturing cost of a phosphor and a light emitting device and a light emitting device using the same.

### [Technical Solution]

According to an aspect of the present invention, there is provided a phosphor, wherein a first phosphor having a chemical formula of Sr₄₋ₓMg_{y}Ba_{z}Si₂O₈:Euₓ²⁺ (0 < x < 1, 0 ≤y≤ 1, 0 ≤ z ≤1) and a second phosphor having a chemical formula of Sr₃₋ₓSiO₅: Eu²⁺ₓ (0 < x ≤ 1) are used with mixed in a fixed ratio.

According to another aspect of the present invention, there is provided a light emitting device including: a light source emitting exciting light; a substrate supporting the light source; a light transmitting member provided in at least one part around the light source; and a phosphor which is mixed in the light transmitting member and in which a first phosphor having a chemical formula of Sr₄₋ₓMg_{y}Ba_{z}Si₂O₈:Euₓ²⁺ (0 < x < 1, 0 ≤y≤ 1, 0 ≤ z ≤ 1) and a second phosphor having a chemical formula of Sr₃-ₓSiO₅:Eu²⁺ₓ (0 < x ≤ 1) are mixed in a fixed ratio.

According to a further aspect of the present invention, there is provided a light emitting device including: a light source emitting exciting light; a light transmitting member provided in at least one part around the light source; and a phosphor which is received in the light transmitting member and in which a first phosphor having a light emitting main peak in a range of 500 to 600nm to a blue color light source and a second phosphor having a light emitting main peak in a range of 550 to 600nm to a blue color light source are mixed in a ratio of 9.9 _{:} 0.1 to 5.0 _{:} 5.0.

According to an even further aspect of the present invention, there is provided a surface mounting-type light emitting device including: a light source; a support supporting the light source; a light transmitting member provided in at least one part around the light source; and a phosphor which is mixed in the light transmitting member and in which a first phosphor having a chemical formula of Sr₄₋ₓMg_{y}Ba_{z}Si₂O₈:Euₓ²⁺ (0 < x < 1, 0 ≤ y ≤ 1, 0 ≤ z ≤ 1) and a second phosphor having a chemical formula of Sr₃₋ₓSiO₅ : Eu²⁺ₓ (0 < x ≤ 1) are mixed in a fixed ratio.

According to a still further aspect of the present invention, there is provided a lamp-type light emitting device including: a light source; a support supporting the light source; a light transmitting member provided in at least one part around the light source; and a phosphor which is mixed in the light transmitting member and in which a first phosphor having a chemical formula of Sr₄₋ₓMg_{y}Ba_{z}Si₂O₈:Euₓ²⁺ (0 < x < 1, 0 ≤ y ≤ 1, 0 ≤ z ≤ 1) and a second phosphor having a chemical formula of Sr₃₋ₓSiO₅:Eu²⁺ₓ (0 < x ≤ 1) are mixed in a fixed ratio.

### [Advantageous Effects]

According to the present invention, it is possible to obtain a phosphor and a light emitting device having an improved characteristic and particularly control a color coordinate, a color temperature, and a color rendering index of a light emitting device.

Further, it is possible to reduce a manufacturing cost of the phosphor and the light emitting device.

### [Description of Drawings]

The above and other features and advantages of the present invention will become more apparent by describing in detail exemplary embodiments thereof with reference to the attached drawings in which:
Fig. 1 is a diagram illustrating a light emitting spectrum of a phosphor depending on a mixed ratio of a first and second silicate phosphors using in the phosphor according to the present invention;
Fig. 2 is a cross-sectional view of a surface mounting-type white light emitting device according to an embodiment of the present invention;
Fig. 3 is a cross-sectional view of a vertical lamp-type white light emitting device according to another embodiment of the present invention; and
Fig. 4 is a diagram illustrating a light emitting spectrum of a white light emitting device according to an embodiment of the present invention.

### [Best Mode]

The present invention will now be described more fully with reference to the accompanying drawings, in which exemplary embodiments of the invention are shown.

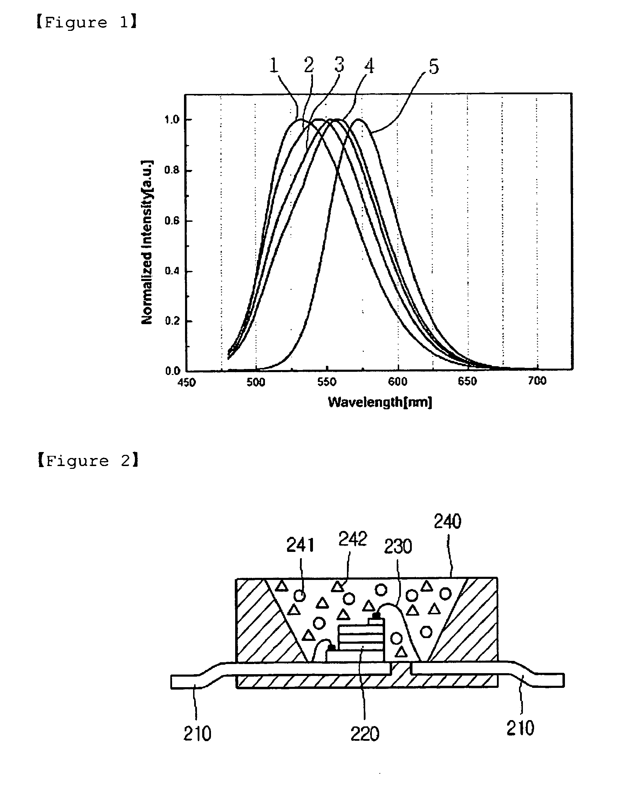

Fig. 1 is a diagram showing a light emitting spectrum of a phosphor depending on the mixed ratio of a first and second silicate phosphors using in the phosphor of the present invention. The respective graphs show a light emitting spectrum of a case where the respective phosphors are excited as an excitation light of 455nm.

Referring to Fig. 1, a first graph 1 shows a light emitting spectrum of a first silicate phosphor having a chemical formula of Sr₄₋ₓMg_{y}Ba_{z}Si₂O₈:Euₓ²⁺ (0 < x < 1, 0 ≤y≤ 1, 0 ≤ z ≤ 1) composing the phosphor of the present invention. A fifth graph 5 shows a light emitting spectrum of a second silicate phosphor having a chemical formula of Sr₃₋ₓSiO₅:Eu²⁺ₓ (0 < x ≤ 1) .

The first silicate phosphor has a main peak of a light emitting spectrum in a range of 500 to 600nm depending on the density of Eu (europium) that is a structural element thereof and the second silicate phosphor has a main peak of a light emitting spectrum in a range of 550 to 600nm depending on the density of Eu that is a structural element. Further, the phosphor of the present invention uses that a main peak of the first and second silicate phosphors changes depending on specific density of Eu and a light emitting main peak thereof changes depending on the mixed ratio of the first and second silicate phosphors.

Hereinafter, a process that a main peak of a light emitting spectrum changes depending on the mixed ratio of the first and second silicate phosphors will be described in detail.

A fourth graph 4 shows a light emitting spectrum of a case where the first silicate phosphor and the second silicate phosphor are mixed in a ratio of 8.5 : 1.5. A third graph 3 shows a light emitting spectrum of a case where the first silicate phosphor and the second silicate phosphor are mixed in a ratio of 9.0 _{:} 1.0. A second graph 2 shows a light emitting spectrum of a case where the first silicate phosphor and the second silicate phosphor are mixed in a ratio of 9.5 _{:} 0.5.

It can be seen that as a ratio of the first silicate phosphor increases, a wavelength of a light emitting main peak is shortened. On the contrary, as a ratio of the second silicate phosphor increases, a wavelength of a light emitting main peak is lengthened.

As can be clearly seen from shown graphs, a light emitting main peak of the phosphor according to the present invention spectrum changes depending on the mixed ratio of the first and second silicate phosphors and has a wide light emitting spectrum area of 500 to 600nm.

Taking into account a relation of such a mixed ratio, it is preferable that the mixed ratio of the first and second silicate phosphors is in a range of 9.9 : 0.1 to 5.0 : 5.0.

In a case where the phosphor according to the present invention is used in a white light emitting device, white light is produced and emitted by the composition of light excited by a phosphor and excitation light.

Now, a light emitting device according to the present invention will be described in detail.

Fig. 2 is a cross-sectional view of a surface mounting-type white light emitting device according to an embodiment of the present invention. As shown in Fig. 2, the surface mounting-type white light emitting device according to an embodiment of the present invention includes a lead frame 210 of an anode and an cathode, a light-emitting diode chip 220 for generating light when applying a voltage, a wire 230 for conducting the lead frame 210 and the light-emitting diode chip 220, a light transmitting resin 240 molded around the light-emitting diode chip 220, and silicate phosphors 241 and 242 distributed in the light transmitting resin 240.

The light-emitting diode chip 220 uses a near ultraviolet ray light-emitting diode chip which generates light having a main peak of a light emitting spectrum in a range of 400 to 480nm by an applied voltage. Further, a laser diode, a surface light emitting laser device, an inorganic electroluminescence device, an organic electroluminescence device, etc. may be used as a light emitting device having a light emitting peak in the same wavelength area in place of the near ultraviolet ray light-emitting diode chip. In a preferable embodiment according to the present invention, a light-emitting diode chip of InGaN that is gallium nitrided based semiconductor is used.

Further, a light transmitting resin 240 using as a molding member may use a light transmitting epoxy resin, a silicone resin, a polyimide resin, a urea resin, an acrylic resin, etc. The light transmitting resin 240 may preferably use a light transmitting epoxy resin or a silicone resin, etc.

Further, the light transmitting resin 240 may entirely mold around the light-emitting diode chip 220, but it may partially mold in a light emitting portion as needed. That is, in case of a small light emitting device, it is preferable to entirely mold around the light-emitting diode chip, but in case of a high output light emitting device, it may be a disadvantage in a uniform distribution of the silicate phosphors 241 and 242 distributed in the light transmitting resin 240 to entirely mold due to the large size of the light-emitting diode chip 220. In this case, it is preferable to partially mold in the light emitting portion.

As the silicate phosphors 241 and 242 distributed in the light transmitting resin 240, a phosphor mixed with the first silicate phosphor 241 having a chemical formula of Sr₄₋ₓMg_{y}Ba_{z}Si₂O₈:Euₓ²⁺ (0 < x < 1, 0 ≤ y ≤ 1, 0 ≤ z ≤ 1) are and the second silicate phosphor 242 having a chemical formula of Sr₃₋ₓSiO₅:Eu²⁺x , (0 < x ≤ 1) which are described in detail above is used.

Here, it is preferable that a mixed ratio of the first silicate phosphor and the second silicate phosphor is in a range of 9.9 : 0.1 to 5.0 : 5.0.

Now, a mixed ratio of the phosphor depending on a form of a light emitting device will be described in detail.

First, in a case where a surface mounting-type white light emitting device is used in a top view type, it is preferable that a mixed ratio of the first silicate phosphor 241 and the second silicate phosphor 242 is in a range of 9.7 : 0.3 to 8.5 : 1.5. Further, it is preferable that a content of the phosphors 241 and 242 to the light transmitting resin 240 is in a range of 10 to 30 wt%.

Further, in a case where a surface mounting-type white light emitting device is used in a side view type, it is preferable that a mixed ratio of the first silicate phosphor 241 and the second silicate phosphor 242 is in a range of 9.5 : 0.5 to 8.0 : 2.0. Further, it is preferable that a content of the phosphors 241 and 242 to the light transmitting resin 240 is in a range of 5 to 20 wt%.

On the other hand, the phosphor according to the present invention may be formed between a PCB and a keypad stacked on the PCB and used as a backlight light source for lightening the keypad. In this case, a mixed ratio of the phosphor according to the present invention and when the light transmitting resin is mixed and molded, a mixed ratio thereof are as follows.

First, in case of a white color phosphor, it is preferable that the first silicate phosphor 241 and the second silicate phosphor 242 are mixed in a range of 9.7 : 0.3 to 8.5 : 1.5 and a content of the phosphors 241 and 242 to the light transmitting resin 240 is in a range of 20 to 50 wt%.

Further, in case of a bluish white color, it is preferable that the first silicate phosphor 241 and the second silicate phosphor 242 are mixed in a range of 9.7 : 0.3 to 8.5 : 1.5 and a content of the phosphors 241 and 242 to the light transmitting resin 240 is in a range of 10 to 40 wt%.

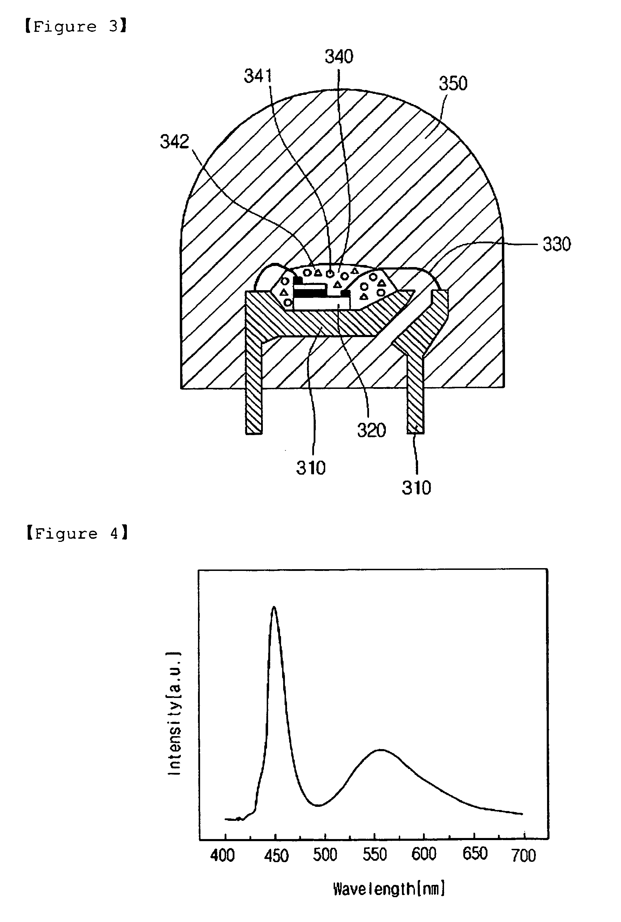

Fig. 3 is a cross-sectional view of a vertical lamp-type white light emitting device according to another embodiment of the present invention.

Referring to Fig. 3, the vertical lamp-type white light emitting device includes a pair of lead frames 310, a light-emitting diode chip 320 for generating light when applying a voltage, a wire 330 for conducting the lead frame 310 and the light-emitting diode chip 320, a light transmitting resin 340 molded around the light-emitting diode chip 320, and silicate phosphors 341 and 342 distributed in the light transmitting resin 340, and a sheathing 350.

The light transmitting resin 340 may entirely mold around the light-emitting diode chip 320, but it may partially mold a light emitting portion as needed.

As the silicate phosphors 341 and 342 distributed in the light transmitting resin 340, as in the surface mounting-type white light emitting device, a phosphor mixed with a first silicate phosphor 341 having a chemical formula of Sr₄₋ₓMg_{y}Ba_{z}Si₂O₈:Euₓ²⁺ (0 < x < 1, 0 ≤ y ≤ 1, 0≤z≤ 1) and a second silicate phosphor 342 having a chemical formula of Sr₃₋ₓSiO₅: Eu²⁺ (0 < x ≤ 1) is used.

Specifically, in the light transmitting resin 340, the first silicate phosphor 341 having a chemical formula of Sr₄₋ₓMg_{y}Ba_{z}Si₂O₈:Euₓ²⁺ (0 < x < 1, 0 ≤ y ≤ 1, 0 ≤ z ≤ 1) emitting light which is excited by excitation light of 400 to 480nm wavelength generated from the light-emitting diode chip 320 and has a light emitting main peak of 500 to 600nm and the second silicate phosphor 342 emitting light which is excited by the excitation light and has a main peak in a range of 550 to 600nm are mixed and molded to enclose the light emitting device chip 320.

A size of average particle of the respective first and second silicate phosphors 341 and 342 is 20µm or less. The size of average particle thereof preferably is in a range of about 5 to 15µm

Here, a mixed ratio of the first silicate phosphor 341 and the second silicate phosphor 342 mixing with the light transmitting resin 340 is in a range of 9.9 : 0.1 to 5.0 : 5.0.

A construction such as the light-emitting diode chip 320, the light transmitting resin 340, and the first and second silicate phosphors 341 and 342 using in the vertical lamp-type of white light emitting device is similar with that of the surface mounting-type white light emitting device and thus the detailed description will be omitted.

On the other hand, it is preferable that a content of the phosphors 341 and 342 to the light transmitting resin 340 according to the present invention applying to a general light emitting device is in a range of 5 to 50 wt%, but a content ratio of a phosphor can be increased so that the content to a light transmitting resin of the phosphor according to the present invention applying to a high output light emitting device is in a range of 50 to 100 wt %.

A process that white light is embodied in the surface mounting-type white light emitting device or the vertical lamp-type white light emitting device according to the present invention will be described in detail.

Blue light (400 to 480nm) corresponding to near ultraviolet rays emitted from the InGaN light-emitting diode chips 220 and 320 passes through the first and second silicate phosphors 241, 242, 341, and 342 before emitting to the outside.

Here, a portion of light excites the first and second silicate phosphors 241, 242, 341, and 342 and generates light having a light emitting main peak in a range of each of 500 to 600nm and 550 to 600nm and the remaining light is transmitted as blue color light.

As a result, as the light excited in the first and second silicate phosphors 241, 242, 341, and 342 and the blue color light just transmitted are mixed, the white light emitting device according to an embodiment of the present invention shows white light.

Fig. 4 is a diagram illustrating a light emitting spectrum of a white light emitting device according to an embodiment of the present invention. Intensity graphs for wavelength band shown in Fig. 4 show a light emitting spectrum of light emitted from the white light emitting device in a case where a mixing ratio of the first silicate phosphor having a chemical formula of Sr₄₋ₓMg_{y}Ba_{z}Si₂O₈:Euₓ²⁺ (0 < x < 1, 0 ≤ y ≤ 1, 0 ≤ z ≤ 1) and the second silicate phosphor having a chemical formula of Sr₃₋ₓSiO₅: Eu²⁺ₓ (0 < x ≤ 1) is 9.0 : 1.0.

Referring to Fig. 4, it can be seen that the white light emitting device according to an embodiment of the present invention emits white light having a spectrum of a wide wavelength of 400 to 700nm.
As already described above, the light emitting main peak of the phosphor changes when a mixing ratio of the first silicate phosphor having a chemical formula of Sr₄₋ₓMg_{y}Ba_{z}Si₂O₈:Euₓ²⁺ (0 < x < 1, 0 ≤ y ≤1, 0 ≤ z ≤1) and the second silicate phosphor having a chemical formula of Sr₃₋ₓSiO₅:EU²⁺ ₓ (0 < x ≤ 1) composing the phosphor according to the present invention is changed and mixed in a light transmitting resin. Further, by using the property, a control of a color coordinate, a color temperature, and a color rendering index of the white light emitting device is possible according to the present invention.

### [Mode for Invention]

A phosphor according to the present invention are is properly mixed with two kinds of silicate phosphors and emits white light and a light emitting device according to the present invention suggests a construction of a detailed light emitting device to which the phosphor is properly applied.

Further, the present invention is characterized in that light having a property different from original light may emit by a specific phosphor mixed in a certain form of light emitting device chip to which a fixed wavelength band of light is emitted and a transparent member provided in the outside of at least one portion of the light emitting device chip. Therefore, a detailed construction of the light emitting device can be changed within the extent of the scope of the present invention.

Further, in the present invention, a specific mixture of a phosphor for emitting white light and a construction of a light emitting device suitable thereto are more preferably suggested.

While the present invention has been particularly shown and described with reference to exemplary embodiments thereof, it will be understood by those skilled in the art that various changes in form and details may be made therein without departing from the scope of the present invention as defined by the appended claims.

### [Industrial Applicability]

According to the present invention, it is possible to provide a white light emitting device having a lower color temperature and a high color rendering index than a white light emitting device using a single phosphor.

Further, by changing a mixed ratio of the first silicate phosphor and the second silicate phosphor, it is possible to control a color coordinate, a color temperature, and color rendering index. Therefore, it is possible to obtain more easily light of a state that a user wants.

Further, a light emitting device according to the present invention provides the practicality using as an energy saving light source which replaces backlight for a color LCD of a cellular phone, a LED lamp, and a LED or a fluorescent light for displaying at the inside of a train and a bus.

## Claims

1. A phosphor,
wherein a first phosphor having a chemical formula of Sr₄₋ₓMg_{y}Ba_{z}Si₂O₈:Euₓ²⁺ (0 < x < 1, 0 ≤ y ≤1, 0 ≤ z ≤ 1) and a second phosphor having a chemical formula of Sr₃₋ₓSiOₛ:Euₓ²⁺ (0 < x ≤ 1) are mixed in a fixed ratio.

2. The phosphor of claim 1, wherein the first phosphor is excited by light having a main peak in a range of 400 to 480nm and has a light emitting main peak in a range of 500 to 600nm.

3. The phosphor of claim 2, wherein the second phosphor is excited by light having a main peak in a range of 400 to 480nm and has a light emitting main peak in a range of 550 to 600nm.

4. The phosphor of claim 1, wherein a ratio of the first phosphor and the second phosphor is in a range of 9.9 : 0.1 to 5.0 : 5.0.

5. The phosphor of claim 1, wherein an average size of a particle of the first phosphor and the second phosphor is 20 µm or less.

6. The phosphor of claim 5, wherein an average size of a particle of the first phosphor and the second phosphor is in a range of 5 to 15 µm.

7. The phosphor of claim 1, wherein excitation light of the phosphor has a main peak in in a range of 400 to 480nm.

8. The phosphor of claim 1, wherein light exciting the phosphor and light excited by the phosphor are composed and emit white light.

9. A light emitting device comprising:
a light source;
a substrate supporting the light source;
a light transmitting member provided in at least one part around the light source; and
a phosphor which is mixed in the light transmitting member and in which a first phosphor having a chemical formula of Sr₄₋ₓMg_{y}Ba _{z} Si₂O₈:Eu ₓ²⁺ (0 < x < 1, 0 ≤y ≤ 1, 0 ≤z ≤1) and a second phosphor having a chemical formula Sr₃₋ₓSiO₅:Euₓ²⁺(0 < x ≤ 1) are mixed in a fixed ratio.

10. The light emitting device of claim 9, wherein when the light emitting device is used in a top view type, a ratio of the first phosphor and the second phosphor is in a range of 9.7 : 0.3 to 8.5 : 1.5.

11. The light emitting device of claim 10, wherein a content of the phosphor to the light transmitting member is in a range of 10 to 30 wt%.

12. The light emitting device of claim 9, wherein when the light emitting device is used in a side view type, a ratio of the first phosphor and the second phosphor is in a range of 9.5 : 0.5 to 8.0 : 2.0.

13. The light emitting device of claim 12, wherein a content of the phosphor to the light transmitting member is in a range of 5 to 20 wt%.

14. The light emitting device of claim 9, wherein when the light emitting device is used in white backlight, a mixed ratio of the first phosphor and the second phosphor is in a range of 9.7 : 0.3 to 8.5 : 1.5.

15. The light emitting device of claim 14, wherein a content of the phosphor to the light transmitting member is in a range of 20 to 50 wt%.

16. The light emitting device of claim 9, wherein when the light emitting device is used in bluish white color backlight, the first phosphor and the second phosphor are mixed in a ratio of 9.7 : 0.3 to 8.5 : 1.5.

17. The light emitting device of claim 16, wherein a content of the phosphor to the light transmitting member is in a range of 10 to 40 wt%.

18. The light emitting device of claim 9, wherein the light transmitting member is molded as a light transmitting resin material.

19. The light emitting device of claim 18, wherein the light transmitting resin member is a silicone resin or an epoxy resin.

20. The light emitting device of claim 9, wherein white color light is emitted after passing through the phosphor layer.

21. The light emitting device of claim 9, wherein the light transmitting member is entirely provided at the outside of the light source.

22. The light emitting device of claim 9, wherein the light transmitting member is partially provided at the outside of the light source.

23. The light emitting device of claim 9, wherein
the first phosphor (341) having a light emitting main peak in a range of 500 to 600nm to a blue color light source and the second phosphor(342) having a light emitting main peak in a range of 550 to 600nm to the blue color light source are mixed in a ratio of 9.9 : 0.1 to 5.0 : 5.0.

24. The light emitting device of claim 23, wherein light emitted from the light source and light excited from the phosphor are together emitted.

25. The light emitting device of claim 9, wherein the light emitting device comprises a surface mounting-type light emitting device

26. The light emitting device of claim 9, wherein the light emitting device comprises a lamp-type light emitting device.

## Patentansprüche

1. Leuchtstoff,
wobei ein erster Leuchtstoff mit einer chemischen Formel Sr₄₋ₓMg_{y}Ba_{z}Si₂O₈:Euₓ²⁺ (0 < x < 1, 0 ≤ y ≤ 1, 0 ≤ z ≤ 1) und ein zweiter Leuchtstoff mit einer chemischen Formel Sr₃₋ₓSiO₅: Euₓ²⁺ (0 < x ≤ 1) in einem festgelegten Verhältnis gemischt sind.

2. Leuchtstoff nach Anspruch 1, wobei der erste Leuchtstoff durch Licht mit einem Hauptpeak in einem Bereich von 400 bis 480 nm angeregt wird und einen Lichtemissionshauptpeak in einem Bereich von 500 bis 600 nm aufweist.

3. Leuchtstoff nach Anspruch 2, wobei der zweite Leuchtstoff durch Licht mit einem Hauptpeak in einem Bereich von 400 bis 480 nm angeregt wird und einen Lichtemissionshauptpeak in einem Bereich von 550 bis 600 nm aufweist.

4. Leuchtstoff nach Anspruch 1, wobei ein Verhältnis des ersten Leuchtstoffs und des zweiten Leuchtstoffs in einem Bereich von 9,9:0,1 bis 5,0:5,0 liegt.

5. Leuchtstoff nach Anspruch 1, wobei eine durchschnittliche Größe eines Partikels des ersten Leuchtstoffs und des zweiten Leuchtstoffs 20 µm oder weniger ist.

6. Leuchtstoff nach Anspruch 5, wobei eine durchschnittliche Größe eines Partikels des ersten Leuchtstoffs und des zweiten Leuchtstoffs in einem Bereich von 5 bis 15µm liegt.

7. Leuchtstoff nach Anspruch 1, wobei Anregungslicht des Leuchtstoffs einen Hauptpeak in einem Bereich von 400 bis 480 nm hat.

8. Leuchtstoff nach Anspruch 1, wobei Anregungslicht des Leuchtstoffs und Licht, das durch den Leuchtstoff angeregt wird, zusammengesetzt sind und weißes Licht ausstrahlen.

9. Lichtemittierende Vorrichtung, umfassend:
eine Lichtquelle;
ein Substrat, das die Lichtquelle trägt;
ein lichtübertragendes Element, das in mindestens einem Teil um die Lichtquelle vorgesehen ist; und
einen Leuchtstoff, der in das lichtübertragende Element eingemischt ist und in dem ein erster Leuchtstoff mit einer chemischen Formel Sr₄₋ₓMg_{y}Ba_{z}Si₂O₈:Euₓ²⁺ (0 < x < 1, 0 ≤ y ≤ 1, 0 ≤ z ≤ 1) und ein zweiter Leuchtstoff mit einer chemischen Formel Sr₃₋ₓSiO₅:Euₓ²⁺ (0 < x ≤ 1) in einem festgelegten Verhältnis gemischt sind.

10. Lichtemittierende Vorrichtung nach Anspruch 9, wobei, wenn die lichtemittierende Vorrichtung bei einer Draufsichtsart verwendet wird, ein Verhältnis des ersten Leuchtstoffs und des zweiten Leuchtstoffs in einem Bereich von 9,7:0,3 bis 8,5:1,5 liegt.

11. Lichtemittierende Vorrichtung nach Anspruch 10, wobei ein Gehalt des Leuchtstoffs zum lichtübertragenden Element in einem Bereich von 10 bis 30 Gew% liegt.

12. Lichtemittierende Vorrichtung nach Anspruch 9, wobei, wenn die lichtemittierende Vorrichtung bei einer Seitenansichtsart verwendet wird, ein Verhältnis des ersten Leuchtstoffs und des zweiten Leuchtstoffs in einem Bereich von 9,5:0,5 bis 8,0:2,0 liegt.

13. Lichtemittierende Vorrichtung nach Anspruch 12, wobei ein Gehalt des Leuchtstoffs zu dem lichtübertragenden Element in einem Bereich von 5 bis 20 Gew% liegt.

14. Lichtemittierende Vorrichtung nach Anspruch 9, wobei, wenn die lichtemittierende Vorrichtung in weißem Hintergrundlicht verwendet wird, ein Mischverhältnis des ersten Leuchtstoffs und des zweiten Leuchtstoffs in einem Bereich von 9,7:0,3 bis 8,5:1,5 liegt.

15. Lichtemittierende Vorrichtung nach Anspruch 14, wobei ein Gehalt des Leuchtstoffs zu dem lichtübertragenden Element in einem Bereich von 20 bis 50 Gew% liegt.

16. Lichtemittierende Vorrichtung nach Anspruch 9, wobei, wenn die lichtemittierende Vorrichtung in einem bläulich weißen Hintergrundlicht verwendet wird, der erste Leuchtstoff und der zweite Leuchtstoff in einem Verhältnis von 9,7:0,3 bis 8,5:1,5 gemischt sind.

17. Lichtemittierende Vorrichtung nach Anspruch 16, wobei ein Gehalt des Leuchtstoffs zu dem lichtübertragenden Element in einem Bereich von 10 bis 40 Gew% liegt.

18. Lichtemittierende Vorrichtung nach Anspruch 9, wobei das lichtübertragende Element als lichtübertragendes Harzmaterial geformt ist.

19. Lichtemittierende Vorrichtung nach Anspruch 18, wobei das lichtübertragende Harzelement ein Silikonharz oder ein Epoxidharz ist.

20. Lichtemittierende Vorrichtung nach Anspruch 9, wobei nach dem Durchgang durch die Leuchtstoffschicht weißes Licht emittiert wird.

21. Lichtemittierende Vorrichtung nach Anspruch 9, wobei das lichtübertragende Element vollständig an der Außenseite der Lichtquelle vorgesehen ist.

22. Lichtemittierende Vorrichtung nach Anspruch 9, wobei das lichtübertragende Element teilweise an der Außenseite der Lichtquelle vorgesehen ist.

23. Lichtemittierende Vorrichtung nach Anspruch 9, wobei der erste Leuchtstoff (341), der einen Lichtemissionshauptpeak in einem Bereich von 500 bis 600 nm zu einer blauen Lichtquelle hat, und der zweite Leuchtstoff (342), der einen Lichtemissionshauptpeak in einem Bereich von 550 bis 600 nm zu der blauen Lichtquelle hat, in einem Verhältnis von 9,9:0,1 bis 5,0:5,0 gemischt sind.

24. Lichtemittierende Vorrichtung nach Anspruch 23, wobei Licht, das von der Lichtquelle ausgestrahlt wird, und Licht, das von dem Leuchtstoff angeregt wird, gemeinsam ausgestrahlt werden.

25. Lichtemittierende Vorrichtung nach Anspruch 9, wobei die lichtemittierende Vorrichtung eine lichtemittierende Vorrichtung vom Oberflächenmontagetyp umfasst.

26. Lichtemittierende Vorrichtung nach Anspruch 9, wobei die lichtemittierende Vorrichtung eine lichtemittierende Vorrichtung vom Leuchtentyp umfasst.

## Revendications

1. Substance luminescente, dans laquelle une première substance luminescente de formule chimique Sr₄₋ₓMg_{y}Ba_{z}Si₂O₈:Euₓ²⁺ (0 < x < 1, 0 ≤ y ≤ 1, 0 ≤ z ≤ 1) et une seconde substance luminescente de formule chimique Sr₃₋ₓSiO₅:Euₓ²⁺ (0 < x ≤ 1) sont mélangées dans un rapport fixe.

2. Substance luminescente selon la revendication 1, dans laquelle la première substance luminescente est excitée par de la lumière ayant un pic principal dans une plage de 400 à 480 nm et présente un pic principal d'émission de lumière dans une plage de 500 à 600 nm.

3. Substance luminescente selon la revendication 2, dans laquelle la seconde substance luminescente est excitée par de la lumière ayant un pic principal dans une plage de 400 à 480 nm et présente un pic principal d'émission de lumière dans une plage de 550 à 600 nm.

4. Substance luminescente selon la revendication 1, dans laquelle un rapport entre la première substance luminescente et la seconde substance luminescente est dans une plage de 9,9 : 0,1 à 5,0 : 5,0.

5. Substance luminescente selon la revendication 1, dans laquelle une taille moyenne de particule de la première substance luminescente et de la seconde substance luminescente est de 20 µm ou moins.

6. Substance luminescente selon la revendication 5, dans laquelle une taille moyenne de particule de la première substance luminescente et de la seconde substance luminescente est dans une plage de 5 à 15 µm.

7. Substance luminescente selon la revendication 1, dans laquelle de la lumière d'excitation de la substance luminescente a un pic principal dans une plage allant de 400 à 480 nm.

8. Substance luminescente selon la revendication 1, dans laquelle de la lumière excitant la substance luminescente et de la lumière excitée par la substance luminescente sont composées et émettent de la lumière blanche.

9. Dispositif émetteur de lumière comprenant :
une source de lumière ;
un substrat supportant la source de lumière ;
un élément transmetteur de lumière disposé en au moins une partie autour de la source de lumière ; et
une substance luminescente qui est mélangée dans l'élément transmetteur de lumière et dans laquelle un première substance luminescente de formule chimique Sr₄₋ₓMg_{y}Ba_{z}Si₂O₈:Euₓ²⁺ (0 < x < 1, 0 ≤ y ≤ 1, 0 ≤ z ≤ 1) et une seconde substance luminescente de formule chimique Sr₃₋ₓSiO₅:Euₓ²⁺ (0 < x ≤ 1) sont mélangées dans un rapport fixe.

10. Dispositif émetteur de lumière selon la revendication 9, dans lequel, quand le dispositif émetteur de lumière est utilisé en vue du dessus, un rapport entre la première substance luminescente et la seconde substance luminescente est dans une plage de 9,7 : 0,3 à 8,5 : 1,5.

11. Dispositif émetteur de lumière selon la revendication 10, dans lequel une teneur en substance luminescente par rapport à l'élément transmetteur de lumière est dans une plage de 10 à 30 % en poids.

12. Dispositif émetteur de lumière selon la revendication 9, dans lequel, quand le dispositif émetteur de lumière est utilisé en vue de côté, un rapport entre la première substance luminescente et la seconde substance luminescente est dans une plage de 9,5 : 0,5 à 8,0 : 2,0.

13. Dispositif émetteur de lumière selon la revendication 12, dans lequel une teneur en substance luminescente par rapport à l'élément transmetteur de lumière est dans une plage de 5 à 20 % en poids.

14. Dispositif émetteur de lumière selon la revendication 9, dans lequel, quand le dispositif émetteur de lumière est utilisé en rétro-éclairage blanc, un rapport de mélange entre la première substance luminescente et la seconde substance luminescente est dans une plage de 9,7 : 0,3 à 8,5 : 1,5.

15. Dispositif émetteur de lumière selon la revendication 14, dans lequel une teneur en substance luminescente par rapport à l'élément transmetteur de lumière est dans une plage de 20 à 50 % en poids.

16. Dispositif émetteur de lumière selon la revendication 9, dans lequel, quand le dispositif émetteur de lumière est utilisé en rétro-éclairage de couleur blanc - bleuâtre, la première substance luminescente et la seconde substance luminescente sont mélangées dans un rapport de 9,7 : 0,3 à 8,5 : 1,5.

17. Dispositif émetteur de lumière selon la revendication 16, dans lequel une teneur en substance luminescente par rapport à l'élément transmetteur de lumière est dans une plage de 10 à 40 % en poids.

18. Dispositif émetteur de lumière selon la revendication 9, dans lequel l'élément transmetteur de lumière est moulé sous la forme d'un matériau en résine transmetteur de lumière.

19. Dispositif émetteur de lumière selon la revendication 18, dans lequel l'élément en résine transmetteur de lumière est une résine de silicone ou une résine époxy.

20. Dispositif émetteur de lumière selon la revendication 9, dans lequel de la lumière de couleur blanche est émise après passage à travers la couche de substance luminescente.

21. Dispositif émetteur de lumière selon la revendication 9, dans lequel l'élément transmetteur de lumière est entièrement disposé à l'extérieur de la source de lumière.

22. Dispositif émetteur de lumière selon la revendication 9, dans lequel l'élément transmetteur de lumière est partiellement disposé à l'extérieur de la source de lumière.

23. Dispositif émetteur de lumière selon la revendication 9, dans lequel
la première substance luminescente (341) ayant un pic principal d'émission de lumière dans une plage de 500 à 600 nm vers une source de lumière de couleur bleue et la seconde substance luminescente (342) ayant un pic principal d'émission de lumière dans une plage de 550 à 600 nm vers une source de lumière de couleur bleue sont mélangées dans un rapport de 9,9 : 0,1 à 5,0 : 5,0.

24. Dispositif émetteur de lumière selon la revendication 23, dans lequel de la lumière émise depuis la source de lumière et de la lumière excitée à partir de la substance luminescente sont émises conjointement.

25. Dispositif émetteur de lumière selon la revendication 9, dans lequel le dispositif émetteur de lumière comprend un dispositif émetteur de lumière de type à montage en surface.

26. Dispositif émetteur de lumière selon la revendication 9, dans lequel le dispositif émetteur de lumière comprend un dispositif émetteur de lumière de type lampe.
